# EUROPÄISCHE PATENTSCHRIFT

(11) **EP 1 329 963 B1**
(45) Veröffentlichungstag und Bekanntmachung des Hinweises auf die Patenterteilung: **30.05.2007**
(21) Anmeldenummer: 02000937.9
(22) Anmeldetag: 16.01.2002
(51) Int. Cl.: H01L 41/053, F16F 15/00

(54) **Sichere Applikation von piezokeramischen Plattenaktoren im Automobil**
Safe mounting of piezoceramic plate actuators in a vehicle
Montage sans danger des actionneurs à plaque piézocéramique dans l'automobile

(43) Veröffentlichungstag der Anmeldung: 23.07.2003
(73) Patentinhaber: Continental Aktiengesellschaft, 30165 Hannover (DE)
(72) Erfinder: Huber, Gerald, Dr., 30175 Hannover (DE)

(56) Entgegenhaltungen:
- WO-A-00/45067
- US-A- 5 645 260
- US-A- 6 138 996
- PATENT ABSTRACTS OF JAPAN vol. 011, no. 380 (M-650), 11. Dezember 1987 (1987-12-11) -& JP 62 151641 A (TOYOTA MOTOR CORP), 6. Juli 1987 (1987-07-06)

## Beschreibung

### Stand der Technik

1. Piezokeramische Aktoren, z. B. in Form von piezokeramischen Platten, - gemäß dem Oberbegriff des Anspruchs 1 - können zur Schwingungsreduktion im Kraftfahrzeug benutzt werden (Fig. 1a, siehe z. B. auch: Huber et al.: "Intelligente Materialien zur Schwingungsreduktion im KFZ", Adaptronic Congress, 2001, Berlin, 4.- 5. April. Oberhalb und unterhalb der Platte sind dünne Elektroden aufgebracht, die mit Spannungen, die im Bereich von bis zu 1 kV liegen, ansteuerbar sind. Für Anwendungen zur Schwingungsreduktion auf metallischen Körpern (z. B. ein Blech) werden die Platten mittels eines Klebstoffes auf die Struktur aufgeklebt. So kann in einer Ausführung eine piezokeramische Platte mittels eines elektrisch leitfähigen Klebstoffes auf die Struktur aufgeklebt werden, die metallische Struktur auf Masse geschaltet werden und die Elektrode auf der Piezokeramik auf Spannung. Durch geeignete elektrische Ansteuerung (negative Bewegungsrückkopplung) ist eine Schwingungsreduktion dann möglich.
   Die Spannung beträgt dabei bis zu 1 kV. Genau dies stellt aber im Automobil ein entscheidendes Sicherheitsrisiko dar, dem entsprechend beigekommen werden muss. Außerdem muss sichergestellt werden, dass die Keramik nicht durch Steinschlag oder andere mechanische Einflüsse zerstört wird.
2. Um obigen Problemen beizukommen, werden piezokeramische Platten in elektrisch nicht leitende Werkstoffe eingebunden. So ist z. B. von "ACX" (Active Control Experts, 215 First Street, Cambridge, MA, USA) ein entsprechend vorgefertigtes Modul käuflich zu erwerben. Die Keramik und die Elektroden sind in eine Harz-Matrix eingegossen. Entsprechende elektrische Anschlüsse sind angebracht.

Nachteil dieser Methode ist, dass zwischen der zu bedämpfenden metallischen Struktur und der Keramik immer eine Schicht von Harz liegt, die mitverformt werden muss. Die Effektivität dieser Aktoren wird also reduziert. Es wäre deutlich besser, die Keramik direkt auf die metallische Struktur aufzukleben. Weiterhin ist die Einbindung in die Harzmatrix aufwendig und das Modul daher teuer.

### Aufgabe, Lösung und Vorteile der Erfindung

Die Aufgabe der vorliegenden Erfindung besteht darin, einen Aufbau und die Fertigstellung einer gattungsgemäßen Anordnung zu beschreiben, wobei die unter 1. und 2. genannten Nachteile des Standes der Technik vermieden werden.

Durch eine *zweischichtige Isolation* ist die Piezokeramik gegenüber der Umgebung zuverlässig elektrisch isoliert.
Indem die Keramik mit einem leitfähigen Klebstoff auf das bezüglich der Schwingung zu beruhigende Bauteil direkt aufgebracht wird, ist die Möglichkeit gegeben, die Piezokeramik sicher, geschützt vor Zerstörung und dabei gleichzeitig effektiv im Auto zu verwenden. Dabei wird das Bauteil als Masse verwendet, und die obere Elektrode (= die nach außen zeigende Elektrode, die unter bis zu 1 kV steht) weist einen entsprechenden elektrischen Anschluss (= Kabel) bereits auf.

Die Isolationsschicht besteht zuerst aus einem *hochisolierenden > 100 kV*/*mm - Schutzlack*, der in einer Schichtdicke von mindestens 0,01 mm aufgebracht wird. Dadurch wird eine elektrische Isolation gegenüber bis zu 1 kV erreicht. Vorzugsweise ist der Lack nicht spröde sondern besitzt elastische Eigenschaften, um die Wirkungsweise des Aktors nicht zu beeinträchtigen. Der Lack wird vorzugsweise durch Sprayen aufgebracht.

Anschließend wird eine *zweite hochelastische Isolationsschicht* aufgebracht, an die für die elektrische Isolation geringere Anforderungen gestellt werden können, da die hauptsächliche elektrische Isolation schon durch die erste Schicht erreicht wird.

Zur weiteren Erhöhung der Sicherheit ist aber auch eine Durchschlagfestigkeit von mindestens 1 kV / mm vorzuziehen. Aufgabe dieser zweiten Schicht ist vielmehr, eine mechanische Isolation zu erreichen. Es handelt sich damit vorzugsweise um einen elektrisch nichtleitenden Kautschuk (*Silikonkautschuk*), der in einer Schichtdicke von > 1 mm aufgebracht wird. Durch diese Schicht können mechanische Stöße abgemildert werden, die sonst zu einer Zerstörung der Keramik führen würden. Daneben wird die Sicherheit nochmals erhöht. Vorzugsweise wird dieser Kautschuk kalt aufgebracht (Piezokeramiken sind temperaturempfindlich) und bei Raumtemperatur vulkanisiert. Die Aufbringung kann durch Verstreichen, Pressen oder Extrudieren erfolgen.

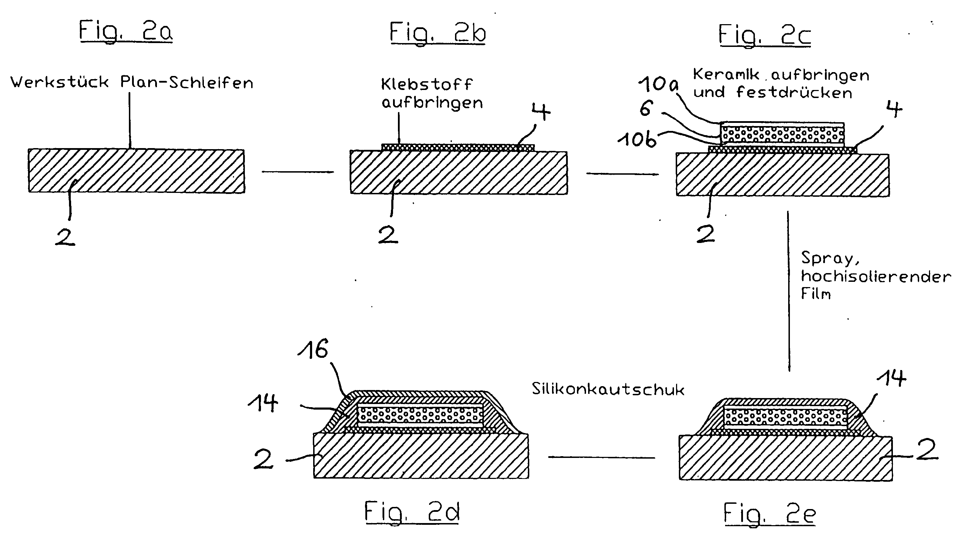

Weitere Vorteile:
- Elektrische und mechanische Isolation der Keramik.
- Einfache und schnelle Fertigung (siehe Schema, Fig. 2a-e, ein extra Eingießen in Harz nicht nötig).
- Temperatur-Abführung im Betrieb im Auto gewährleistet (direkter Kontakt zu Metall, das ein guter Wärmeleiter ist. Im Fall von "ACX" ist die Keramik in ein Harz eingegossen, das die Wärme schlechter ableitet. Wärmeableitung ist wichtig, da sonst die Keramik überhitzen kann und zerstört werden kann.)
- Gleichzeitig gute mechanische und elektrische Eigenschaften durch zwei Schichten (Vorteil gegenüber jeweils einer Schicht.)
- Alle Vorteile werden gleichzeitig erzielt.

### Zeichnungen

Ein Ausführungsbeispiel der Erfindung ist in den Zeichnungen dargestellt und wird in der nachfolgenden Beschreibung erläutert. Es zeigt:
Fig. 1a einen Aufbau gemäß dem zu (1) genannten Stand der Technik;

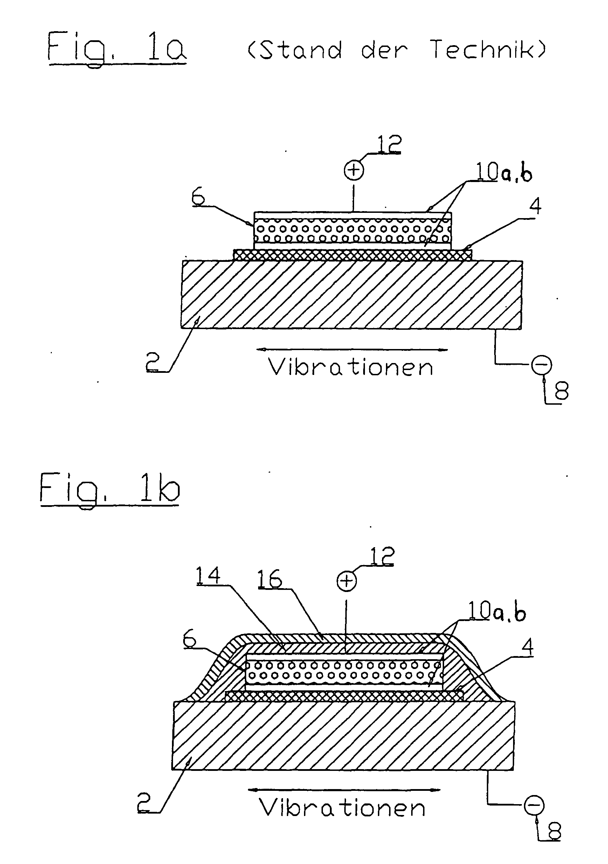

Fig. 1b einen erfindungsgemäßen Aufbau.
Der Ablauf des erfindungsgemäßen Fertigstellungsverfahrens ist in den Fig. 2a bis Fig. 2e dargestellt.

### Beschreibung der Erfindung

Mit dem Bezugszeichen "2" ist in Fig. 1a und 1b ausschnittsweise ein Bauteil eines Kraftfahrzeugs, bzw. allgemein: eine metallische Struktur gekennzeichnet. Dieses Bauteil 2 (z. B. ein Motorträger) ist ein aktiv schwingendes Gebilde, dessen Vibrationen unerwünscht sind und deshalb minimiert werden sollen.
Zu diesem Zweck ist mittels eines elektrisch leitenden Klebstoffes 4 eine piezoelektrische Keramik 6 auf der metallischen Struktur 2 befestigt. In Verbindung mit dem elektrisch leitenden Klebstoff 4 stellt die metallische Struktur 2 eine Elektrode der Piezokeramik 6 dar, die am Fahrzeug mit "Masse" 8 verbunden ist. Zwischen Klebstoff 4 und Piezokeramik 6 liegt in der Regel auch eine Elektrode 10b (siehe Abbildungen).

An der der metallischen Struktur 2 gegenüberliegenden Seite ist die Keramik 6 mit einer Elektrode 10a versehen, die mit dem (Plus-)Pol 12 einer Spannungsquelle verbunden ist. Ein solcher Aufbau entspricht dem unter "Stand der Technik" zu (1) beschriebenen.

Die erfindungswesentliche Neuerung ergibt sich aus Fig. 1b: Direkt auf der Piezokeramik 6 befindet sich ein hochisolierender (> 100 kV / mm) Schutzlack 14 von einer Dicke > 0,01 mm. Darauf befindet sich eine zweite, hochelastische Isolationsschicht 16 aus Silikonkautschuk in einer Schichtdicke von > 1 mm.

### Bezugszeichenliste

### (ist Teil der Beschreibung)

- 2: Bauteil, metallische Struktur, vibrierende Oberfläche
- 4: elektrisch leitender Klebstoff
- 6: piezoelektrische Keramik, Piezokeramik, Aktor, piezoelektrische Platte
- 8: "Masse", Elektrode
- 10a, 10b: Elektrode
- 12: (Plus-)Pol, Spannung
- 14: hochisolierender Schutzlack, erste Schicht, erste Lage
- 16: hochelastische Isolationsschicht, zweite Schicht, zweite Lage, Silikonkautschuk
- 14, 16: zweilagige Schutzschicht

## Patentansprüche

1. Anordnung mit piezokeramischem Aktor, insbesondere in Plattenform, zur Schwingungsreduktion einer metallischen Struktur (2) an einem Kraftfahrzeug,
wobei der piezokeramische Aktor eine Piezokeramik (6) und Elektroden (4, 10a, 10b) umfasst die oberhalb und unterhalb der Piezokeramik (6) angeordnet sind und die mit Spannung (12) im Bereich von bis zu 1 kV ansteuerbar sind,
wobei der piezokeramische Aktor mittels eines elektrisch leitfähigen Klebstoffes (4) an der zu dämpfenden metallischen Struktur (2) befestigt ist,
wobei wiederum die metallische Struktur (2) auf Masse (8) und die auf der Piezokeramik (6) befindliche Elektrode (10a) an die Spannung (12) anschließbar ist,
**gekennzeichnet durch**
eine zweilagige Schutzschicht (14, 16) auf dem piezokeramischen Aktor zur Isolierung gegenüber der Umgebung.

2. Anordnung nach Anspruch 1,
**dadurch gekennzeichnet,**
**dass** die erste Schicht (14) ein hochisolierender Schutzlack von mindestens 0,01 mm Dicke und einer Durchschlagfestigkeit von mehr als 100 kV/mm ist.

3. Anordnung nach Anspruch 1 oder 2,
**dadurch gekennzeichnet,**
**dass** die zweite Schicht (16) eine hochelastische Isolationsschicht in einer Dicke von > 1 mm ist.

4. Anordnung nach einem der Ansprüche 1 bis 3,
**dadurch gekennzeichnet,**
**dass** die zweite Schicht (16) ein kaltaufgebrachter Silikonkautschuk ist.

5. Verfahren zur sicheren Applikation eines piezokeramischen Aktors, insbesondere in Plattenform, zur Schwingungsreduktion einer metallischen Struktur (2) an einem Kraftfahrzeug,
wobei der piezokeramische Aktor eine Piezokeramik (6) und Elektroden (4, 10a, 10b) umfasst die oberhalb und unterhalb der Piezokeramik (6) aufgebracht sind und die mit Spannung (12) im Bereich von bis zu 1 kV ansteuerbar sind,
wobei der piezokeramische Aktor mittels eines elektrisch leitfähigen Klebstoffes (4) auf die zu dämpfende, metallische Struktur (2) aufgeklebt worden ist,
wobei wiederum die metallische Struktur (2) auf Masse (8) und die auf der Piezokeramik (6) befindliche Elektrode (10a) an eine Spannung (12) angeschlossen ist,
**dadurch gekennzeichnet,**
**dass** schließlich eine zweilagige, gegenüber der Umgebung wirksame, Isolationsschicht (14, 16) auf den piezokeramischen Aktor aufgebracht wird.

6. Verfahren nach Anspruch 5,
**dadurch gekennzeichnet,**
**dass** zuerst ein hochisolierender Schutzlack (14) von mindestens 0,01 mm Dicke und einer Durchschlagfestigkeit von mehr als 100 kV/mm ist auf die Piezokeramik (6) aufgebracht wird.

7. Verfahren nach Anspruch 6,
**dadurch gekennzeichnet,**
**dass** der Schutzlack (14) durch Sprayen aufgebracht wird.

8. Verfahren nach einem der Ansprüche 5 bis 7,
**dadurch gekennzeichnet,**
**dass** eine zweite, hochelastische Isolationsschicht (16) in einer Dicke von > 1 mm auf die erste Lage (14) aufgebracht wird.

9. Verfahren nach Anspruch 8,
**dadurch gekennzeichnet,**
**dass** zweite, hochelastische Isolationsschicht (16) als ein Silikonkautschuk kalt aufgebracht wird.

10. Verfahren nach Anspruch 9,
**dadurch gekennzeichnet,**
**dass** das Aufbringen des Silikonkautschuks (16) durch Verstreichen, Pressen oder Extrudieren erfolgt.

## Claims

1. Arrangement with a piezoceramic actuator, in particular in plate form, for reducing the vibration of a metallic structure (2) on a motor vehicle, the piezoceramic actuator comprising a piezoceramic (6) and electrodes (4, 10a, 10b) which are arranged above and below the piezoceramic (6) and which can be activated by a voltage (12) in the range up to 1 kV, the piezoceramic actuator being fastened by means of an electrically conductive adhesive (4) on the metallic structure (2) to be damped, the metallic structure (2) in turn being connectable to earth (8) and the electrode (10a) located on the piezoceramic (6) being connectable to the voltage (12), **characterized by** a two-layered protective coating (14, 16) on the piezoceramic actuator for insulation from the surroundings.

2. Arrangement according to Claim 1, **characterized in that** the first coating (14) is a highly insulating protective lacquer with a thickness of at least 0.01 mm and a dielectric strength of over 100 kV/mm.

3. Arrangement according to Claim 1 or 2, **characterized in that** the second coating (16) is a highly elastic insulating coating in a thickness of > 1 mm.

4. Arrangement according to one of Claims 1 to 3, **characterized in that** the second coating (16) is a cold-applied silicone rubber.

5. Method of safely mounting a piezoceramic actuator, in particular in plate form, for reducing the vibration of a metallic structure (2) on a motor vehicle, the piezoceramic actuator comprising a piezoceramic (6) and electrodes (4, 10a, 10b) which are applied above and below the piezoceramic (6) and which can be activated by a voltage (12) in the range up to 1 kV, the piezoceramic actuator having been adhesively bonded by means of an electrically conductive adhesive (4) on the metallic structure (2) to be damped, the metallic structure (2) in turn being connected to earth (8) and the electrode (10a) located on the piezoceramic (6) being connected to a voltage (12), **characterized in that** finally a two-layered insulating coating (14, 16), which is effective with respect to the surroundings, is applied to the piezoceramic actuator.

6. Method according to Claim 5, **characterized in that** first a highly insulating protective lacquer (14) of a thickness of at least 0.01 mm and a dielectric strength of over 100 kV/mm is applied to the piezoceramic (6).

7. Method according to Claim 6, **characterized in that** the protective lacquer (14) is applied by spraying.

8. Method according to one of Claims 5 to 7, **characterized in that** a second, highly elastic insulating layer (16) in a thickness of > 1 mm is applied to the first coating (14).

9. Method according to Claim 8, **characterized in that** a silicone rubber is applied cold as the second, highly elastic insulating coating (16).

10. Method according to Claim 9, **characterized in that** the application of the silicone rubber (16) is performed by brushing, pressing or extruding.

## Revendications

1. Système à actionneur piézocéramique, en particulier en forme de plaque, pour la réduction des vibrations d'une structure métallique (2) d'un véhicule automobile, l'actionneur piézocéramique comprenant une piézocéramique (6) et des électrodes (4, 10a, 10b) qui sont disposées au-dessous et en dessous de la piézocéramique (6) et qui peuvent être alimentées en une tension (12) de l'ordre de jusque 1 kV,
l'actionneur piézocéramique étant fixé au moyen d'un adhésif (4) sur la structure métallique (2) à amortir, la structure métallique (2) pouvant elle-même être raccordée à la masse (8) et l'électrode (10a) située sur la piézocéramique (6) à la tension (12),
**caractérisé par** une double couche de protection (14, 16) placée sur l'actionneur piézocéramique pour l'isoler vis-à-vis de l'environnement.

2. Système selon la revendication 1, **caractérisé en ce que** la première couche (14) est un vernis de protection à haute isolation d'une épaisseur d'au moins 0,01 mm et dont la résistance au claquage est supérieure à 100 kV/mm.

3. Système selon les revendications 1 ou 2, **caractérisé en ce que** la deuxième couche (16) est une couche d'isolation à haute élasticité dont l'épaisseur est > 1 mm.

4. Système selon l'une des revendications 1 à 3, **caractérisé en ce que** la deuxième couche (16) est un caoutchouc au silicone appliqué à froid.

5. Procédé pour appliquer de manière sûre un actionneur piézocéramique, en particulier en forme de plaque, pour la réduction des vibrations d'une structure métallique (2) d'un véhicule automobile, l'actionneur piézocéramique comprenant une piézocéramique (6) et des électrodes (4, 10a, 10b) qui sont disposées au-dessous et en dessous de la piézocéramique (6) et qui peuvent être alimentées en une tension (12) de l'ordre de jusque 1 kV,
l'actionneur piézocéramique étant collé au moyen d'un adhésif (4) sur la structure métallique (2) à amortir, la structure métallique (2) étant elle-même raccordée à la masse (8) et l'électrode (10a) située sur la piézocéramique (6) à la tension (12),
**caractérisé en ce qu'**enfin une double couche (14, 16) d'isolation vis-à-vis de l'environnement est appliquée sur l'actionneur piézocéramique.

6. Procédé selon la revendication 5, **caractérisé en ce qu'**un vernis de protection (14) à haute isolation, d'une épaisseur d'au moins 0,01 mm et dont la résistance au placage est supérieure à 100 kV/mm est d'abord appliqué sur la piézocéramique (6).

7. Procédé selon la revendication 6, **caractérisé en ce que** le vernis de protection (14) est appliqué par pulvérisation.

8. Procédé selon l'une des revendications 5 à 7, **caractérisé en ce qu'**une deuxième couche d'isolation (16) à haute élasticité dont l'épaisseur est > 1 mm est appliquée sur la première couche (14).

9. Procédé selon la revendication 8, **caractérisé en ce que** comme deuxième couche d'isolation (16) à haute élasticité, on applique à froid un caoutchouc au silicone.

10. Procédé selon la revendication 9, **caractérisé en ce que** l'application du caoutchouc au silicone (16) s'effectue par étalement, pressage ou extrusion.
